# EUROPEAN PATENT APPLICATION

(11) **EP 0 827 195 A1**
(43) Date of publication of application: **04.03.1998**
(21) Application number: 97306564.2
(22) Date of filing: 27.08.1997
(51) Int. Cl.: H01L 21/768, H01L 21/60

(54) **Improvements in or relating to semiconductor devices**

(30) Priority: 28.08.1996 US 25041 P
(71) Applicant: TEXAS INSTRUMENTS INC., Dallas, Texas 75243 (US)
(72) Inventor: Kaeriyama, Toshiyuki, Ibariki-Ken (JP)
(74) Representative: Williams, Janice

(57) **Abstract**

An improved method of forming a contact hole 122 through an insulating layer 112 is disclosed herein. In one embodiment, a first mask layer 110 (e.g. polysilicon or photoresist) is formed over the insulating layer 112. The first mask layer 110 is patterned and etched to expose a portion of the insulating layer 112. The exposed portion of the insulating layer 112 is then etched to form a contact hole having a bottom surface and an inner side surface. A sidewall mask later 120 (or sidewall pipe 120) is formed along the inner surface of the contact hole. The bottom surface of the contact hole is then etched using the sidewall mask layer 120 as an etch mask to form a contact hole 122. Finally, the contact hole can be filled with a conductive material.

## Description

### FIELD OF THE INVENTION

This invention generally relates to semiconductor devices, and in a specific example to the formation of contacts for semiconductor devices.

### BACKGROUND OF THE INVENTION

Semiconductor devices are continuously getting faster and more powerful. As the need arises for chips with more devices integrated on them, the individual elements which form these integrated circuits must become smaller. For example, dynamic random access memory (DRAM) devices with over 64 million memory have been built and those with over 256 million and even over one billion memory bits are being designed. Current microprocessors can include three million transistors or even more. Further, large memory devices are being integrated with processors or other circuitry.

As more elements are integrated on a single chip, the interconnection of these elements becomes more critical. In known interconnection techniques, a contact hole may be formed in an insulating later using standard lithography methods. This contact hole can then be filled with a conducting material such as polysilicon or metal. The size of the contact holes (or via) is limited by the smallest dimension standard lithography techniques can create.

### SUMMARY OF THE INVENTION

Respective aspects of the present invention are set forth in claims 1, 13 and 17.

An improved method of forming a contact hole through an insulating layer is disclosed herein. In one embodiment, a first mask layer (e.g. polysilicon or photoresist) is formed over the insulating layer. The first mask layer is patterned and etched to expose a portion of the insulating layer. The exposed portion of the insulating layer is then etched to form a contact hole having a bottom surface and an inner side surface. A sidewall mask layer (or sidewall pipe) is formed along the inner surface of the contact hole. The bottom surface of the contact hole is then etched using the sidewall mask layer as an etch mask to form a contact hole. Finally, the contact hole can be filled with a conductive metal.

Embodiments of the invention have a number of advantages over prior art processes. By using a sidewall pipe, a contact hole which is smaller than the limit of photolithography resolution can easily be realized. The sidewall pipe can minimize the critical dimension loss of the contact hole during etching. This minimization is due to the etch selectivity between oxides and polysilicon or nitride. In addition, the alignment registration can be minimized by forming smaller contact holes. Also, the sidewall pipe can be used to insulate the contact hole from adjacent interconnects. Thus, the contact hole interconnection will not short to other interconnects.

### BRIEF DESCRIPTION OF THE DRAWINGS

The above features of the present invention will be more clearly understood from consideration of the following descriptions of illustrative embodiments in connection with accompanying drawings in which:
Figures 1a-1e illustrate a prior art process for forming a contact hole;
Figures 2a-2h illustrate a preferred embodiment process of the present invention;
Figure 3 illustrates a DRAM device as an example of a structure which utilizes the contact embodying the invention; and
Figures 4-8 illustrate alternate embodiment devices of the present invention

Corresponding numerals and symbols in the different figures refer to corresponding parts unless otherwise indicated.

### DETAILED DESCRIPTION OF ILLUSTRATIVE EMBODIMENTS

The making and use of the various embodiments are discussed below in detail. However, it should be appreciated that the present invention provides many applicable inventive concepts which can be embodied in a wide variety of specific contexts. The specific embodiments discussed are merely illustrative of specific ways to make and use the invention, and do not limit the scope of the invention.

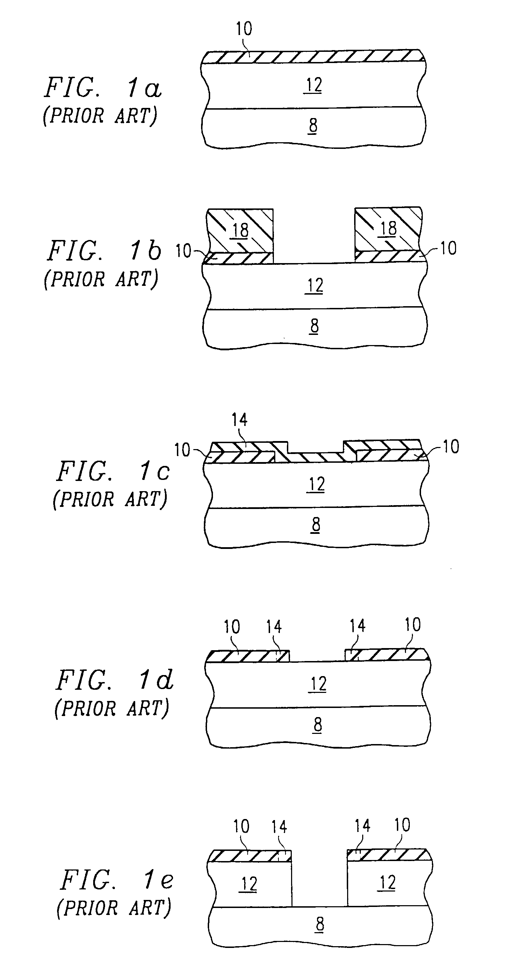

A prior art process for forming a via will first be described with respect to Figures 1a-1e. As shown in Figure 1a, a first polysilicon layer 10 is deposited over an insulating region 12. In figure 1b the first polysilicon layer 10 is patterned and etched to expose a portion of insulating region 12. A second polysilicon layer 14 is then formed over device. As shown in Figure 1c, the second polysilicon layer 14 covers the top and side surfaces of the first polysilicon layer 10 as well as the exposed portion of insulating region 12.

As illustrated in Figure 1d, a polysilicon etch is next performed to remove a thickness of polysilicon greater than the thickness of the second polysilicon later 14. This process leaves polysilicon sidewalls 14 along the contact hole which was formed in the first polysilicon layer 10. The polysilicon 10/14 can then be used as an etch mask to create a via through the insulating region 12. This via is illustrated in Figure le.

The process of Figures 1a-1e provides the advantage that the final etch mask 10/14 was smaller than the original patterning of the polysilicon layer 10. In other words, this process allowed for smaller feature size than the lithography would allow.

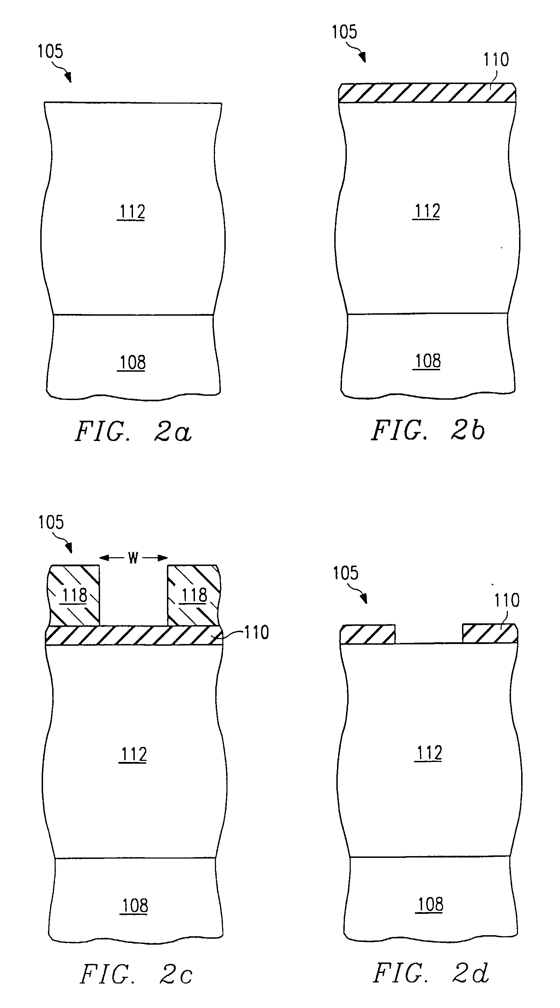

An improved process will now be described with respect to Figures 2a-2h. A narrow cross-section of an exemplary device 105 is illustrated in Figure 2a. The goal of the presently described process will be to form a contact hole or via through the insulating layer 112 to expose a portion of underlying layer 108. The device 105 can comprise any type of semiconductor device. For example, this process may be used in the fabrication of memory devices, processors, general logic devices or other devices.

The insulating layer 112 may comprise an oxide such as silicon dioxide. Alternatively, the insulating layer 112 may comprise a glass layer such as BPSG or PSG. The insulating layer 112 may also comprise multiple layers (some of which may be conductive or semiconductive). The underlying layer 108 may be a conductive (or semiconductive) material such as silicon or a metal layer. Alternatively, the underlying layer 108 may be an insulator. The specific composition of underlying layer 108 is not critical to the present invention.

In figure 2b, a first mask layer 110 is formed over the insulating layer 112. In one embodiment, the first mask layer 110 comprises about 1000Å of polysicilon. Alternatively, a nitride material can be used. In fact, any material which allows insulating layer 112 to be selectively etched can be used for form mask layer 110.

Referring next to Figure 2c, a resist layer 118 is patterned over the mask layer 110. Resist layer 118 can comprise any photoresist or other masking material. A portion of resist layer W microns wide has to be removed to expose a portion of the mask layer 110. The width W is limited in how small it can be by the properties of the resist system. One goal of the present invention is to create a contact hole which is narrower than the width W. At present, photolithography technology can create a feature size of about 0.35 microns wide (i.e. W∼0.3µm).

As illustrated in Figure 2d, the exposed portion of the first mask layer 110 is etched and the resist 118 is removed. The hole etched in first mask layer will be approximately W microns in diameter. This etched portion can be any shape although a circular contact is presently preferred.

In an alternate embodiment which is not illustrated, photoresist layer 188 may be used as the first mask layer 110. In this embodiment, resist layer 118 could be formed directly on insulating layer 112. The resist layer 118 would then be patterned as illustrated in Figure 2c. The subsequent processing would be the same except that resist layer 118 would replace first mask layer 110 in the following descriptions.

Next the exposed portion of insulating layer 112 is etched to form the top portion of contact hole 119 as shown in Figure 2e. During this etching step, the mask layer 110 is used as an etch mask. If insulating layer 112 is a silicon dioxide layer, an etch with a selectivity greater than 10 can be performed if mask layer 110 is a nitride layer and a selectivity greater than 20 can be achieved if mask later 110 is a silicon (e.g. polysilicon) layer. In one example, the contact hole 119 may be formed to a depth of about D, where the ratio D:W between the depth D and the width W is between about 1:2 and 6:1. For example, the ensuing hole 119 may be between about 0.2 and 0.3 µm deep (and about 0.35 µm wide).

A second mask layer 120 is formed over the device 105. As shown in Figure 2f, the second mask layer 120 covers the inner and bottom surfaces of contact hole 118. In one embodiment, the second mask layer 120 is between about 500Å and 1000Å thick. In general, the ratio T:W between the thickness T of mask layer 120 and the width W of contact hole 119 is between about 1:8 and 1:3. But other ratios are possible. The thickness T of mask layer 120 is only constrained by the relationship 0<T<W/2.

As with mask layer 110, any material which allows insulating layer 112 to be selectively etched can be used to form mask layer 120. The first mask layer 100 may be formed from the same or from a different material than second mask layer 120. As examples, the second mask layer 120 may comprise a nitride (e.g.,Si₃N₄) or polysilicon. For example, a 500 to 100Å layer of silicon nitride can be deposited by low pressure chemical vapor deposition (LPCVD).

The portion of second mask layer 120 abutting the bottom of contact hole 119 is then removed as illustrated in Figure 2g. This process step will expose the bottom surface of contact hole 119. In all likelihood, the portion of mask layer 120 overlying the first mask layer 110 will also be removed. The resulting mask structure 120 can be referred to as a sidewall mask 120 since it is disposed along the sidewall of contact hole portion 119. The mask layer 120 can also be referred to as sidewall pipe 120 because of its cylindrical shape when the contact hole 118 is circular.

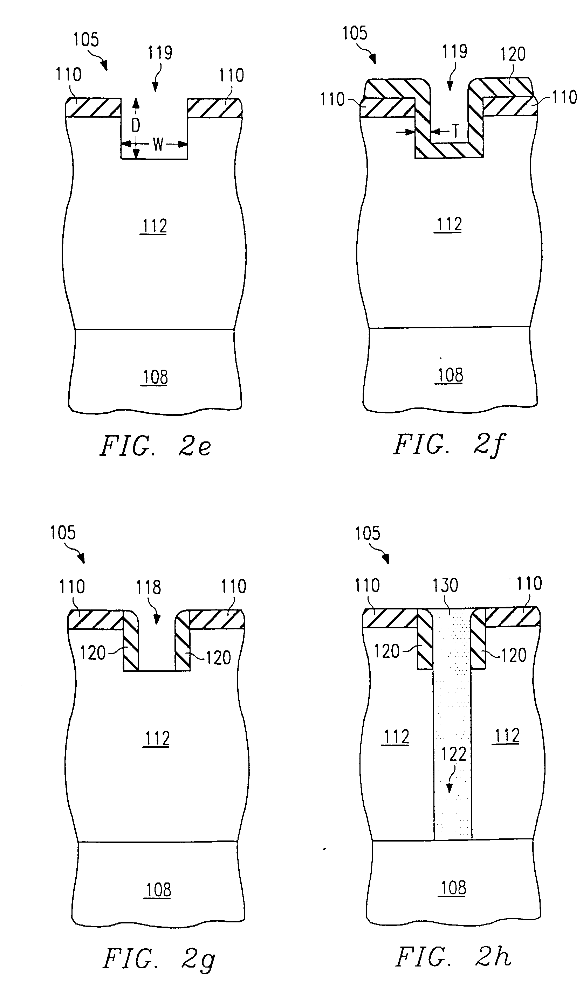

Referring next to Figure 2h, the contact hole 122 is completed by etching the bottom surface of contact hole portion 119 using sidewall mask layer 120 as an etch mask. If insulating layer 112 is a silicon dioxide layer, an etch with a selectivity greater than 10 can be performed if mask layers 110 and 120 are nitride and a selectivity greater than 20 can be achieved if mask layers 110 and 120 are silicon.

The contact hole will be approximately W - 2T microns wide where W is the width of the contact hole portion 118 and T is the thickness of sidewall mask layer 120. As an example, if contact hole portion 118 was 0.35µm wide and mask layer 120 was 500Å (or 0.05µm) thick, the contact hole 122 would be about 0.25µm wide.

It is noted that this process provides for the formation of a sublithographic contact hole. In this description, a sublithographic featureisone which is smaller than could be formed using photolithography techniques. At this time, features as small as 0.32µ can be formed and therefore sublithographic would mean less than 0.32µm. It is anticipated, however, further improvements will be made in the field of photolithography and therefore, in time, sublithographic features would be smaller.

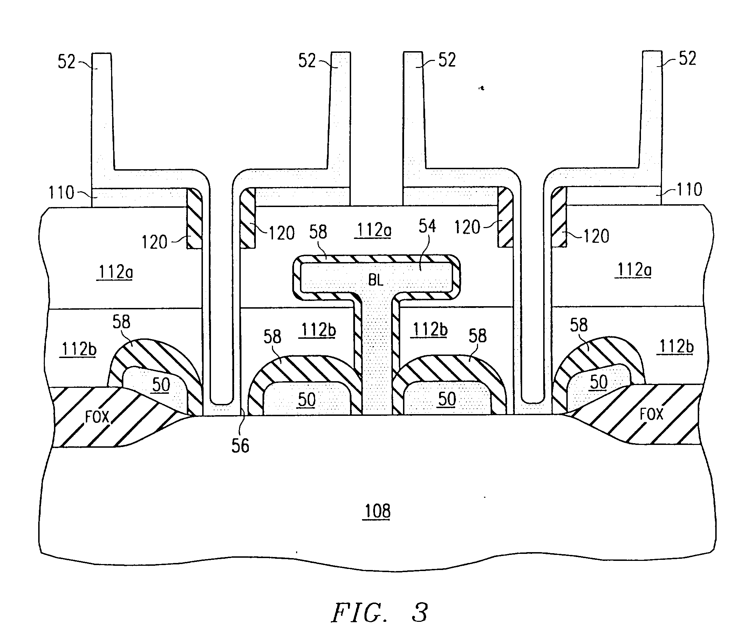

Once the contact hole 122 is complete, it may be filled with a conductive material such as doped polysilicon or a metal to create a contact. This contact 130 would electrically couple the abutting portion of underlying layer 108 with a conductor which overlies the contact 130.
A specific example of an application of the process embodying the present invention will now be described with respect to Figure 3. Figure 3 illustrates two incomplete dynamic random access memory (DRAM) cells. Each cell includes a pass transistor which is controlled by a word line 50. The pass transistor is located to couple the bit line (BL) 54 to a capacitor. Figure 3 illustrates one plate 52 (e.g. the storage node) of this capacitor. The other plate will be formed over the first plate 52 and electrically insulated therefrom. As is known, the other plate (not shown) will be charged to a constant potential. The first plate 52 will then be charged to either a low or high potential corresponding to a logic "O" or "1". Transfer gate 50 is used to read or write a signal to the memory cell through bit line 54.

In large memory arrays, where the dimensions of each of the elements is small, it is often difficult to contact many of the elements. For example, in a 64 Meg DRAM process, the spacing between word lines can be less than 0.3µm and the spacing between bit lines can be less than 0.8µm. The storage node contact 56 is formed between word lines 50. In a typical case, the storage node contact 56 may be no greater than 0.36µm.

In a preferred embodiment process, the storage node contact hole is formed using a self-aligned contact (SAC) process. This process utilizes the high selectivity of oxide etching as compared with nitride in order to protect the word line 50 and bit line 54 (each of which is surrounded by a nitride file 58). In the preferred embodiment, the selectivity is greater than 10.

But a number of problems exist with the prior art method of forming a contact. First, a hole which is less than 0.3µm in diameter cannot be printed with current photolithography process and equipment capabilities. Second, the photolithography alignment registration is less than 0.08µm between two layers and about 0.124µm between three layers. Also, there tends to be about 0.1µm critical dimension loss during the etching step for a 5000Å deep contact hole. Because of these kind of problems, a very small contact hole cannot be formed directly through the bit line and word line without contacting them.

The process described with respect to Figures 2a-2h however, can be used to form the storage node contact hole 56. The present invention can enable a contact hole with is about 1.0µm deep (or even deeper) and still narrow enough to align to the bit line and word line without touching either. With this method of forming a contact hole, the process burden to the self-aligned contact etch can be minimized.

Figure 3 illustrates the sidewall pipe 120 which has been used in order to form narrow contact hole 56. While the present invention has been exemplified with one particular application, it is noted that it could be utilized in a great many other areas. For example, this contact process could have been used for the bit line contact 54 illustrated in Figure 3. In other examples, the present invention could be used along with the production of other semiconductor devices such as processors (e.g. digital signal processors, microprocessors), controllers, logic devices, or other memories (e.g.SRAM, EPROM, EEPROM, flash).

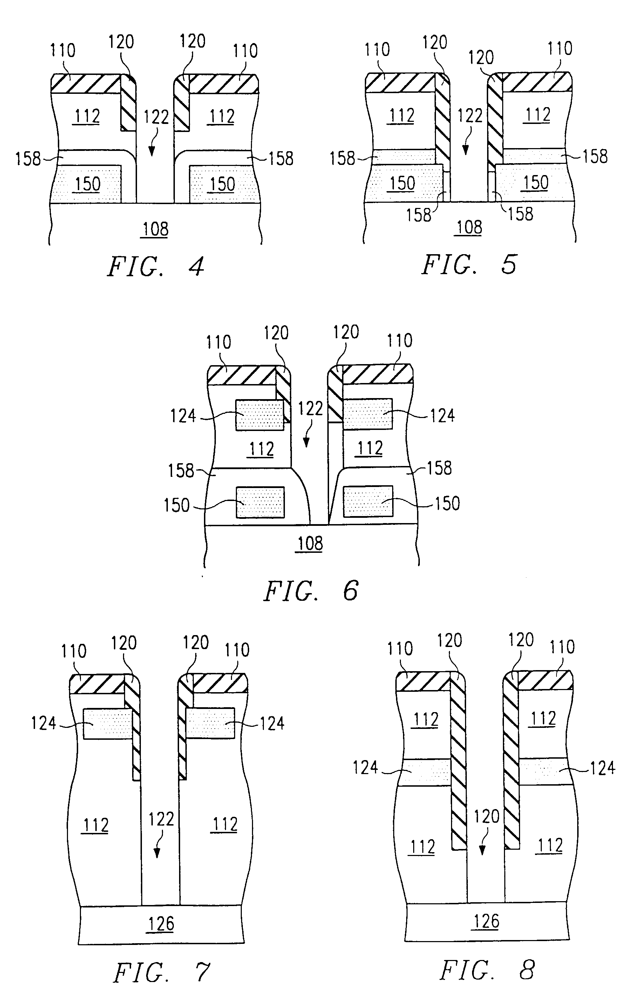

Figures 4-8 illustrate other embodiments of the present invention. Each of these embodiments can be utilized with any kind of semiconductor device including, but not limited to, those listed above.

In Figure 4, a contact hole 122 is recessed in an oxide layer 112 and then a sidewall pipe 120 is formed. In one specific example, a contact hole 122 of about 0.5µm is recessed in the middle of oxide 112. A nitride (or polysilicon) sidewall pipe 120 is then formed. As the size of contact hole 122 becomes about 0.2µm, an 0.08µm alignment registration can be absorbed. Therefore, contact hole 122 can be aligned between regions 150. In one embodiment, the regions 150 are conductors (e.g. doped polysilicon) surrounded by a nitride layer 158. For example, these regions could be the word lines of a DRAM device (see Figure 3).

Figure 5 illustrates a modification of the embodiment of Figure 4. In this embodiment, the contact hole 122 can be larger. In this case, conducting regions 150 can be insulated from the contact hole 122 by the sidewall pipe 120. Since the sidewall pipe 120 will insulate the conducting region 150, the initial contact hole etch can expose the regions 150. In this embodiment, a normal oxide etch condition can be used to form the contact hole rather than a self-aligned etch. Since the region 150 can be exposed, the encapsulating layer 158 can be formed from the same material as insulator 112. For example, both regions can be oxides.

In the embodiment of Figure 6, another layer of conductor 124 is disposed within insulating region 112. This conductor 124 can be insulated from the contact hole 122 by the sidewall pipe 120. This insulation will prevent the conductor 124 from shorting out to the contact formed within contact hole 122. In one example, conductors 124 are spaced by about 0.3µm. A 0.5µm contact is formed between conductors 124. The exposed portions of conductors 124 are then passivated by sidewall pipe 120. In the next process step, contact hole 122 is etched through to underlying layer 108. In this case, a self-aligned etch process can be used (i.e.insulating region 158 is a different material than insulating region 112 so that region 112 will be etched while region 158 is not).

Figure 7 illustrates yet another embodiment of the present invention. In this example, contact hole 122 passes between metal interconnects 124. In one example, interconnects 124 may be about 0.3µm apart. The sidewall pipe 120 will then insulate the conducting region 124 from the contact hole 122. In this manner, interconnects 124 will be fully passivated.

Figure 8 illustrates an example of forming a deep contact hole 122 to underlying interconnection 125 through interconnection 124. In this example, interconnection 124 can be a wide plate like a bus line. Recessed contact hole 122 is formed through oxide 112 and wide interconnection 124. Then sidewall pipe 120 is formed to passivate (i.e. insulate) winder interconnection 124 from contact interconnection 122.

While this invention has been described with reference to illustrative embodiments, this description is not intended to be construed in a limiting sense. Various modifications and combinations of the illustrative embodiments, as well as other emodiments of the invention, will be apparent to persons skilled in the art upon reference to the description.

## Claims

1. A method of forming a contact via through an insulating layer, the method comprising the steps of:
forming a first mask layer over the insulating layer;
patterning and etching the first mask layer to expose a portion of the insulating layer;
etching the exposed portion of the insulating layer to form a contact hole having a bottom surface and an inner side surface;
forming a sidewall mask layer along the inner surface of the contact hole; and
etching the bottom surface of the contact hole using the sidewall mask layer as an etch mask to form said contact via.

2. The method of Claim 1 further comprising:
filling the contact via with a conductive material.

3. The method of Claim 1 or Claim 2 wherein the step of forming the first mask later comprises forming a silicon layer.

4. The method of Claim 1 or Claim 2, wherein the step of forming the first mask layer comprises forming a nitride layer.

5. The method of Claim 1 or Claim 2, wherein the step of forming the first mask layer comprises depositing photoresist.

6. The method of any of Claims 1 to 5 wherein the step of forming said sidewall mask layer comprises forming a silicon layer.

7. The method of any of Claims 1 to 5 wherein the step of forming said sidewall mask layer comprises forming a nitride layer.

8. The method of any of Claims 1 to 5 wherein the step of forming the contact hole comprises forming a contact hole that is no greater than 0.25 microns wide.

9. The method of any of Claims 1 to 8 wherein the step of forming the insulating layer comprises depositing an oxide material.

10. The method of any preceding claim further comprising forming said insulating layer from an insulating material said insulating material including a conductor disposed therein such that the sidewall mask layer electrically insulates the conductor disposed within the insulating material from the conductive material disposed within the contact via.

11. The method of any of Claims 1 to 9, further comprising forming said insulating layer from an insulating material, said insulating material including a conductor disposed therein and encapsulating the conductor with an insulating material which is a different material than the insulating layer.

12. The method of any preceding claim wherein the step of etching the bottom surface comprises performing a self-aligned etching step.

13. An interconnect structure comprising:
an insulating region with a contact via formed therein;
a sidewall pipe formed within the contact via, wherein the sidewall pipe is formed from an insulating material which is different than the insulating region, and
a conductive region filling the contact via.

14. The structure of Claim 13 further comprising;
a second conductive region disposed within the insulating region adjacent the contact via the second conductive region being electrically insulated from the conductive region by the sidewall pipe.

15. The structure of Claim 13 or Claim 14, wherein the conductive region fills a sublithographic contact via.

16. The structure of any of Claims 13 to 15, wherein the sidewall pipe comprises a nitride material.

17. A semiconductor device comprising:
first and second conductive regions formed over a semiconductor layer;
an insulating layer overlying the first and second conductive regions;
an interconnect formed within the insulating layer and contacting the semiconductor later between the first and second conductive regions wherein the interconnect comprises an insulating material surrounding a conductive material, wherein the insulating material is a different material than the insulating layer.

18. The device of Claim 17, wherein the insulating layer comprises an oxide layer and the insulating material comprises a nitride material.

19. The device of Claim 17 or Claim 18, wherein the device is a DRAM device and wherein the first and second conductive regions each comprise word lines and the interconnect comprises a portion of a capacitor.
